# EUROPEAN PATENT SPECIFICATION

(11) **EP 4 339 698 B1**
(45) Date of publication and mention of the grant of the patent: **03.12.2025**
(21) Application number: 21962933.4
(22) Date of filing: 05.11.2021
(51) Int. Cl.: H10K 59/38, G02F 1/1335, G02F 1/1339, H10K 59/80, H10K 102/00

(54) **DISPLAY PANEL, FABRICATION METHOD THEREFOR, AND DISPLAY DEVICE**
ANZEIGETAFEL, HERSTELLUNGSVERFAHREN DAFÜR UND ANZEIGEVORRICHTUNG
ÉCRAN D'AFFICHAGE, SON PROCÉDÉ DE FABRICATION ET DISPOSITIF D'AFFICHAGE

(43) Date of publication of application: 20.03.2024
(73) Proprietor: BOE Technology Group Co., Ltd., Chaoyang District, Beijing 100015 (CN); Yunnan Invensight Optoelectronics Technology Co., Ltd., Yunnan 650211 (CN)
(72) Inventor: YANG, Zongshun, Beijing 100176 (CN); ZHANG, Dacheng, Beijing 100176 (CN); HUANG, Kuanta, Beijing 100176 (CN); CHEN, Xiaochuan, Beijing 100176 (CN)
(74) Representative: Brötz, Helmut
(86) International application number: PCT/CN2021/128964
(87) International publication number: WO 2023/077419

(56) References cited:
- CN-A- 104 166 265
- CN-A- 104 459 861
- CN-A- 105 652 506
- CN-A- 106 647 010
- CN-A- 106 773 250
- US-A1- 2005 083 452
- US-A1- 2013 334 507
- US-A1- 2021 066 400

## Description

### TECHNICAL FIELD

The embodiments of the present disclosure relate to a display panel, a manufacturing method thereof, and a display apparatus.

### BACKGROUND

In a display apparatus, color crosstalk is prone to occur between adjacent color sub-pixels, especially in a display apparatus with high pixel density (Pixel Per Inch, PPI for short). For example, in a micro-display apparatus with high PPI, a size of a sub-pixel is very small, and a spacing between adjacent sub-pixels is also very small, for example, from 3µm to 8µm, in this case, color crosstalk is more likely to occur. Usually a shading black matrix is used to define a plurality of sub-pixels, so that the light-shielding black matrix is used to block crosstalk light between the sub-pixels, so as to prevent the phenomenon of color crosstalk.
US 2013/0334507 A1 discloses a layered color filter which can improve optical selectivity, without reducing optical transparency, an organic EL light emitting device on which such a layered color filter is mounted, and a fabrication method of such an organic EL light emitting device. The layered color filter includes a substrate, a red color filter, a green color filter, and a blue color filter disposed on the substrate. In the layered color filter, the organic EL light emitting device on which such a layered color filter is mounted, and the fabrication method thereof, at least one color filter among the red color filter, the green color filter, and the blue color filter is laminated to be formed as a plurality of thin film layers.
US 2021/066400 A1 discloses a preparation method of a color film layer, a display substrate and a preparation method thereof. The display substrate includes a bearing layer and repeating units, each repeating unit including a green film layer, a red film layer and a blue film layer, which are provided on the bearing layer and directly contacting a first surface of the bearing layer. On a plane parallel to the first surface of the bearing layer, in each repeating unit, the red film layer is provided on a first side of the green film layer, the blue film layer is provided on a second side of the green film layer opposite to the first side; one of the red film layer and the blue color film layer covers part of the green film layer; one part of the green film layer does not overlap with the red film layer and the blue film layer.

### SUMMARY

At least one embodiment of the present disclosure provides a display panel, the display panel comprises a substrate and a plurality of sub-pixels. The substrate includes a main surface; the plurality of sub-pixels are arranged on the main surface of the substrate in an array, each of the plurality of sub-pixels includes a light-emitting device and a color filter on a light-emitting side of the light-emitting device; the color filter of the plurality of sub-pixels includes a first color filter and a second color filter that are adjacent, light transmission color of the first color filter and light transmission color of the second color filter are different from each other, light transmittance of the second color filter is smaller than light transmittance of the first color filter; the first color filter includes a first light-transmitting portion and a first peripheral portion, the first light-transmitting portion is configured to allow light of the sub-pixels where the first light-transmitting portion is located to pass through to emit from the display panel; the first peripheral portion at least partially surrounds the first light-transmitting portion, and the first peripheral portion includes a first portion located on a side of the first light-transmitting portion close to the second color filter; the second color filter includes a second light-transmitting portion and a second peripheral portion, the second light-transmitting portion is configured to allow light of the sub-pixels where the second light-transmitting portion is located to pass through to emit from the display panel; the second peripheral portion at least partially surrounds the second light-transmitting portion, and the second peripheral portion includes a first portion located on a side of the second light-transmitting portion close to the first color filter; the first portion of the second peripheral portion includes a plurality of sub-layers that are at least partially overlapped and spaced apart from each other in a longitudinal direction perpendicular to the main surface of the substrate, the plurality of sub-layers include a first sub-layer and a second sub-layer, and at least a part of the first portion of the first peripheral portion is located between the first sub-layer and the second sub-layer in the longitudinal direction;
the first portion of the first peripheral portion comprises an inner portion, the inner portion is sandwiched between the first sub-layer and the second sub-layer, wherein the inner portion is overlapped with both the first sub-layer and the second sub-layer in the longitudinal direction; the first sub-layer covers and contacts a surface of the inner portion facing the substrate, and the second sub-layer covers and contacts a surface of the inner portion away from the substrate; the first sub-layer is on a side of the second sub-layer close to the substrate; an orthographic projection of the first sub-layer on the main surface of the substrate is within an orthographic projection of the second sub-layer on the main surface of the substrate, and an area of the orthographic projection of the first sub-layer on the main surface of the substrate is smaller than an area of the orthographic projection of the second sub-layer on the main surface of the substrate; a direction in which the first color filter and the second color filter are arranged is a lateral direction; and a width of the first sub-layer in the lateral direction is smaller than a width of the second sub-layer in the lateral direction.

For example, in the display panel provided by at least one embodiment of the present disclosure, the second color filter is a blue color filter that allows blue light to pass through.

For example, in the display panel provided by at least one embodiment of the present disclosure, the first portion of the first peripheral portion further comprises an outer portion, the inner portion is sandwiched between the first sub-layer and the second sub-layer, wherein the inner portion is overlapped with both the first sub-layer and the second sub-layer in the longitudinal direction; the outer portion is integral with the inner portion and on a side of the inner portion close to the first light-transmitting portion in the lateral direction, wherein the outer portion is not overlapped with the first sub-layer, and is overlapped with the second sub-layer in the longitudinal direction.

For example, in the display panel provided by at least one embodiment of the present disclosure, the outer portion covers a side surface of the first sub-layer and is in contact with the side surface of the first sub-layer, and the side surface of the first sub-layer is intersected with the lateral direction.

For example, in the display panel provided by at least one embodiment of the present disclosure, the first sub-layer is on a side of the second sub-layer close to the substrate; and a thickness of the first sub-layer in the longitudinal direction is greater than a thickness of the second sub-layer in the longitudinal direction.

For example, in the display panel provided by at least one embodiment of the present disclosure, the first portion of the first peripheral portion comprises a plurality of sub-layers that are at least partially overlapped in the longitudinal direction and are spaced apart from each other in the longitudinal direction; and the plurality of sub-layers of the first portion of the first peripheral portion and the plurality of sub-layers of the first portion of the second peripheral portion are alternately stacked in the longitudinal direction.

For example, in the display panel provided by at least one embodiment of the present disclosure, among the plurality of sub-layers of the first portion of the first peripheral portion and the plurality of sub-layers of the first portion of the second peripheral portion, the first sub-layer is closest to the substrate.

For example, the display panel provided by at least one embodiment of the present disclosure further comprises a flat layer, the flat layer covers the main surface of the substrate, and has a flat surface away from the substrate, the first color filter and the second color filter are located on the flat surface, and the first sub-layer is in contact with the flat surface.

For example, in the display panel provided by at least one embodiment of the present disclosure, among the plurality of sub-layers of the first portion of the first peripheral portion and the plurality of sub-layers of the first portion of the second peripheral portion, the second sub-layer is farthest away from the substrate.

For example, in the display panel provided by at least one embodiment of the present disclosure, the plurality of sub-layers of the first portion of the second peripheral portion are arranged in the longitudinal direction, and in a direction from close to the substrate to away from the substrate, thicknesses of the plurality of sub-layers in the longitudinal direction of the first portion of the second peripheral portion gradually decrease.

For example, in the display panel provided by at least one embodiment of the present disclosure, a direction in which the first color filter and the second color filter are arranged is a lateral direction; the plurality of sub-layers of the first portion of the second peripheral portion are arranged in the longitudinal direction, in a direction from close to the substrate to away from the substrate, widths of the plurality of sub-layers of the first portion of the second peripheral portion in the lateral direction gradually increase.

For example, in the display panel provided by at least one embodiment of the present disclosure, the color filter of the plurality of sub-pixels further comprises a third color filter adjacent to the second color filter and on a side of the second color filter away from the first color filter, light transmission colors of the first color filter, the second color filter and the third color filter are different from each other, the light transmittance of the second color filter is smaller than a light transmittance of the third color filter; the third color filter comprises a third light-transmitting portion and a third peripheral portion, the third light-transmitting portion is configured to allow light of the sub-pixel where the third light-transmitting portion is located to pass through to emit from the display panel; the third peripheral portion at least partially surrounds the third light-transmitting portion, and the third peripheral portion comprises a first portion on a side of the third light-transmitting portion close to the second color filter; the second peripheral portion further comprises a second portion on a side of the second light-transmitting portion close to the third color filter; the second portion of the second peripheral portion comprises a plurality of sub-layers that are at least partially overlapped in the longitudinal direction perpendicular to the main surface of the substrate and are spaced apart from each other in the longitudinal direction, the plurality of sub-layers of the second portion of the second peripheral portion comprises a third sub-layer and a fourth sub-layer, and at least a part of the first portion of the third peripheral portion is between the third sub-layer and the fourth sub-layer in the longitudinal direction.

For example, in the display panel provided by at least one embodiment of the present disclosure, the first color filter is a green color filter that allows green light to pass through, and the third color filter is a red color filter that allows red light to pass through.

For example, in the display panel provided by at least one embodiment of the present disclosure, the second color filter is substantially axisymmetric with respect to a symmetry axis along the longitudinal direction, and the first peripheral portion and the third peripheral portion are substantially axisymmetric with respect to the symmetry axis.

For example, in the display panel provided by at least one embodiment of the present disclosure, a cross section of the second color filter in the longitudinal direction is in a shape of I.

For example, in the display panel provided by at least one embodiment of the present disclosure, one of the first color filter, one of the second color filter, and one of the third color filter which are sequentially arranged in sequence constitute a repeating unit, and a plurality of the repeating units are repeatedly arranged to provide one of the color filter for each of the plurality of sub-pixels.

For example, in the display panel provided by at least one embodiment of the present disclosure, in one of the repeating units, the first peripheral portion further comprises a second portion on a side of the first light-transmitting portion away from the second color filter, and the third peripheral portion further comprises a second portion on a side of the third light-transmitting portion close to the first color filter; and the second portion of the first peripheral portion comprises a plurality of sub-layers that are at least partially overlapped in the longitudinal direction perpendicular to the main surface of the substrate and are spaced apart from each other in the longitudinal direction, the plurality of sub-layers of the first peripheral portion comprise a fifth sub-layer and a sixth sub-layer, and at least a part of a second portion of the third peripheral portion of the third color filter in the repeating unit adjacent to the one of the repeating units is located between the fifth sub-layer and the sixth sub-layer in the longitudinal direction.

For example, in the display panel provided by at least one embodiment of the present disclosure, in one of the repeating units, a shape and a size of the second portion of the first peripheral portion are same as a shape and a size of the first portion of the second peripheral portion, respectively; and a shape and a size of the second portion of the third peripheral portion are respectively same as a shape and a size of the first portion of the first peripheral portion.

For example, in the display panel provided by at least one embodiment of the present disclosure, a cross section of the third color filter in the longitudinal direction is in a shape of T.

For example, the display panel provided by at least one embodiment of the present disclosure further comprises a pixel definition layer, the pixel definition layer defines openings of the plurality of the sub-pixels of the pixel array, wherein the light-emitting device are at least partially located in the openings; an orthographic projection of the first light-transmitting portion, an orthographic projection of the second light-transmitting portion, and an orthographic projection of the third light-transmitting portion on the main surface of the substrate are respectively located in orthographic projections of the openings of the sub-pixels corresponding to the first color filter, the second color filter, and the third color filter on the main surface of the substrate respectively, and an orthographic projection of the first peripheral portion, an orthographic projection of the second peripheral portion, and an orthographic projection of the third peripheral portion on the main surface of the substrate are all within an orthographic projection of the pixel definition layer on the main surface of the substrate.

At least one embodiment of the present disclosure provides a display apparatus, the display apparatus comprises any one of the display panel provided by the embodiments of the present disclosure.

### BRIEF DESCRIPTION OF THE DRAWINGS

In order to clearly illustrate the technical solution of the embodiments of the present disclosure, the drawings of the embodiments will be briefly described. It is apparent that the described drawings are only related to some embodiments of the present disclosure and thus are not limitative of the present disclosure.
FIG 1 is a planar schematic diagram of a display panel provided by at least one embodiment of the present disclosure;
FIG 2A is a cross-sectional schematic diagram taken along a line A-A' in FIG 1;
FIG 2B is a partial schematic diagram of a color filter layer in FIG 2A;
FIG 2C is an enlarged schematic diagram of a part L in FIG 2B;
FIG 2D is a partial enlarged diagram of another display panel provided by an embodiment at a same position L as in FIG 2B;
FIG 3 is a schematic diagram of still another display panel provided by at least one embodiment of the present disclosure;
FIG 4 is a schematic diagram of a display apparatus provided by at least one embodiment of the present disclosure; and
FIG 5A to FIG 5D are schematic diagrams of a method for manufacturing a display panel provided by at least one embodiment of the present disclosure.

### DETAILED DESCRIPTION

In order to make objects, technical details and advantages of embodiments of the present disclosure clear, the technical solutions of the embodiments will be described in a clearly and fully understandable way in connection with the related drawings. It is apparent that the described embodiments are just a part but not all of the embodiments of the present disclosure. Based on the described embodiments herein, those skilled in the art can obtain, without any inventive work, other embodiment(s) which should be within the scope of the present disclosure.

Unless otherwise defined, all the technical and scientific terms used herein have the same meanings as commonly understood by one of ordinary skill in the art to which the present disclosure belongs. The terms "first," "second," etc., which are used in the description and claims of the present disclosure, are not intended to indicate any sequence, amount or importance, but distinguish various components. The terms "comprises," "comprising," "includes," "including," etc., are intended to specify that the elements or the objects stated before these terms encompass the elements or the objects listed after these terms as well as equivalents thereof, but do not exclude other elements or objects. The phrases "connect", "connected", etc., are not intended to define a physical connection or a mechanical connection, but may comprise an electrical connection which is direct or indirect. The terms "on," "under," "left," "right" and the like are only used to indicate relative position relationship, and in a case that the position of an object is described as being changed, the relative position relationship may be changed accordingly.

At least one embodiment of the present disclosure provides a display panel, and the display panel includes a substrate and a plurality of sub-pixels. The substrate includes a main surface; the plurality of sub-pixels are arranged on the main surface of the substrate in an array, each of the plurality of sub-pixels includes a light-emitting device and a color filter on a light-emitting side of the light-emitting device; the color filter of the plurality of sub-pixels includes a first color filter and a second color filter that are adjacent, light transmission color of the first color filter and light transmission color of the second color filter are different from each other, light transmittance of the second color filter is smaller than light transmittance of the first color filter; the first color filter includes a first light-transmitting portion and a first peripheral portion, the first light-transmitting portion is configured to allow light of the sub-pixels where the first light-transmitting portion is located to pass through to emit from the display panel; the first peripheral portion at least partially surrounds the first light-transmitting portion, and the first peripheral portion includes a first portion located on a side of the first light-transmitting portion close to the second color filter; the second color filter includes a second light-transmitting portion and a second peripheral portion, the second light-transmitting portion is configured to allow light of the sub-pixels where the second light-transmitting portion is located to pass through to emit from the display panel; the second peripheral portion at least partially surrounds the second light-transmitting portion, and the second peripheral portion includes a first portion located on a side of the second light-transmitting portion close to the first color filter; the first portion of the second peripheral portion includes a plurality of sub-layers that are at least partially overlapped and spaced apart from each other in a longitudinal direction perpendicular to the main surface of the substrate, the plurality of sub-layers include a first sub-layer and a second sub-layer, and at least a part of the first portion of the first peripheral portion is located between the first sub-layer and the second sub-layer in the longitudinal direction. The light emitted by the light-emitting layer passes through the color filter of each of the sub-pixels and emits colored light corresponding to the color filter, overlapping positions of the color filters of different colors do not emit light, so that color display is realized.

At least one embodiment of the present disclosure further provides a display apparatus, and the display apparatus includes any one of the display panels provided by the embodiments of the present disclosure.

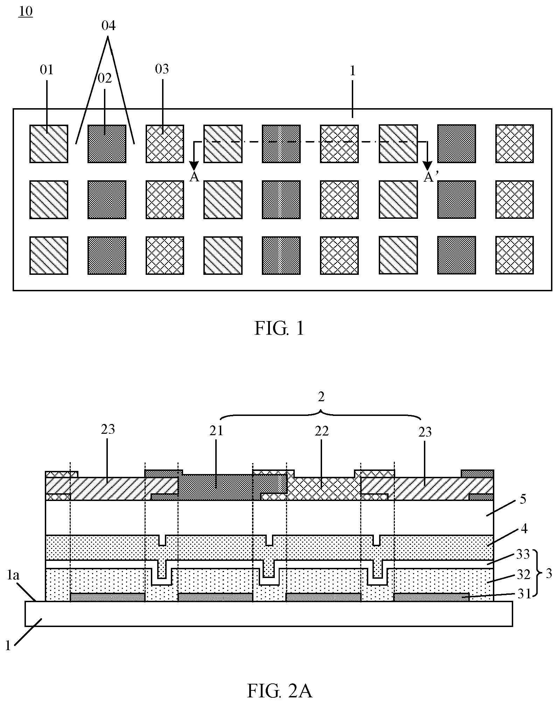

Exemplarily, FIG 1 is a planar schematic diagram of a display panel provided by at least one embodiment of the present disclosure, and FIG 2A is a cross-sectional schematic diagram taken along a line A-A' in FIG 1. As shown in FIG 1, the display panel 10 provided by at least one embodiment of the present disclosure includes a substrate 1 and a plurality of sub-pixels 01/02/03. The substrate 1 includes a main surface 1a; the plurality of sub-pixels 01/02/03 are arranged on the main surface 1a of the substrate 1 in an array, each of the plurality of sub-pixels 01/02/03 includes a light-emitting device 3 and a color filter 21/22/23 located on a light-emitting side of the light-emitting device 3. Regions represented by the numerals 01, 02, and 03 in FIG 1 represent light-emitting regions of the plurality of sub-pixels; and the display panel 10 further includes non light-emitting regions 04 located among the light-emitting regions of adjacent sub-pixels. For example, as shown in FIG 2A, the light-emitting device 3 includes an anode 31, a light-emitting layer 32 and a cathode 33, the light-emitting layer 32 is located between the anode 31 and the cathode 33, for example, the cathode 33 is a continuous integral electrode covering the plurality of sub-pixels. For example, light emitted by the light-emitting layer 32 is white light, the light emitted by the light-emitting layer 32 passes through the color filter of each of the plurality of sub-pixels to emit color light corresponding to the color filter, overlapping positions of the color filters of different colors do not emit light, so that the color display is realized. In the display panel provided by the embodiment of the present disclosure, the light emitted by the light-emitting layer passes through two color filters with low transmittance in the overlapping positions, so that it is beneficial to reduce light transmittance of the non light-emitting regions, and a better light blocking effect is obtained in the non light-emitting regions, in addition, crosstalk light is better blocked in the non light-emitting regions, thereby the crosstalk phenomenon between adjacent sub-pixels is better prevented. In the embodiments of the present disclosure, the non light-emitting regions located between the light-emitting regions of adjacent sub-pixels are non-display regions.

For example, the light-emitting device 3 is an organic light-emitting diode (OLED) or an inorganic light-emitting diode. However, the light-emitting device 3 is not limited to the kind listed here.

For example, in the embodiment shown in FIG 1A, the substrate 1 is a silicon-based substrate. The manufacturing process of the silicon-based substrate is mature, and the performance of the silicon-based substrate is stable, which is suitable for manufacturing highly integrated micro display apparatus. For example, the display apparatus is a silicon-based micro organic light-emitting diode display apparatus.

As shown in FIG 2A to FIG 2B, the color filter of the plurality of sub-pixels includes a first color filter 21 and a second color filter 22 that are adjacent, light transmittance color of the first color filter 21 and light transmittance color of the second color filter 22 are different from each other, and light transmittance of the second color filter 22 is smaller than light transmittance of the first color filter 21.

Because the light transmittance color of the first color filter 21 and the light transmittance color of the second color filter 22 are different from each other, colors of the light that the first color filter 21 and the second color filter 22 respectively allow to pass through are different. Therefore, a position where the first color filter 21 and the second color filter 22 are overlapped with each other in the longitudinal direction perpendicular to the main surface 1a of the substrate 1 is opaque. Similarly, in the display panel 10, colors of the color filters of adjacent sub-pixels are different, positions where the color filters of the adjacent sub-pixels are overlapped with each other in the longitudinal direction are all opaque.

Referring to FIG 2A to FIG 2B, the first color filter 21 includes a first light-transmitting portion 210 and a first peripheral portion, the first light-transmitting portion 210 is configured to allow the light of the sub-pixel where the first light-transmitting portion 210 is located to pass through the first light-transmitting portion 210 to emit from the display panel 10; the first peripheral portion at least partially surrounds the first transparent portion 210, and includes a first portion 211 located on a side of the first light-transmitting portion 210 close to the second color filter 22, the region where the first peripheral portion is located is a non light-emitting region (non-display region); the second color filter 22 includes a second light-transmitting portion 220 and a second peripheral portion, the second light-transmitting portion 220 is configured to allow light of the sub-pixel where the second light-transmitting portion 220 is located to pass through the second light-transmitting portion 220 to emit from the display panel 10; the second peripheral portion at least partially surrounds the second light-transmitting portion 220, and includes a first portion 221 located on a side of the second light-transmitting portion 220 close to the first color filter 21, the region where the second peripheral portion is located is a non light-emitting region (non-display region); the first portion 221 of the second peripheral portion includes a plurality of sub-layers that are at least partially overlapped in the longitudinal direction perpendicular to the main surface 1a of the substrate 1 and are spaced apart from each other in the longitudinal direction. For example, in the present embodiment, the plurality of sub-layers include a first sub-layer 221a and a second sub-layer 221b, the first sub-layer 221a and the second sub-layer 221b are at least partially overlapped in the longitudinal direction and are spaced apart from each other in the longitudinal direction; in the longitudinal direction, at least a part of the first portion 211 of the first peripheral portion is located between the first sub-layer 221a and the second sub-layer 221b, for example, at least a part of the first portion 211 of the first peripheral portion is sandwiched between the first sub-layer 221a and the second sub-layer 221b. For example, the first light-transmitting portion 210 is integral with the first peripheral portion. For example, the second light-transmitting portion 220 is integral with the second peripheral portion. Because the light transmittance of the second color filter 22 is smaller than the light transmittance of the first color filter 21, therefore, a plurality of sub-layers of the second color filter 22, i.e. the first sub-layer 221a and the second sub-layer 221b, are arranged at the position where the second color filter 22 and the first color filter 21 are overlapped, in the case that the light from the light-emitting layer 32 reaches the overlapping region (that is, the non light-emitting region) where the second color filter 22 and the first color filter 21 are overlapped, the light emitted by the light-emitting layer sequentially passes through the first sub-layer 221a, the first portion 211 of the first peripheral portion and the second sub-layer 221b, therefore, the light emitted by the light-emitting layer will pass through two color filters with lower light transmittance, so that it is beneficial to reduce the light transmittance of the non light-emitting region, and a better light-blocking effect in the non light-emitting region is obtained, and the crosstalk light is better blocked in the non light-emitting region, and thereby better prevention of crosstalk between the adjacent sub-pixels is achieved.

For example, the second color filter 22 is a blue color filter that allows blue light to pass through. Because a filter of blue color has a lower light transmittance compared with filters of other colors, experiments have shown that the light blocking effect in the non light-emitting region is better by using the filter of blue color as the second color filter 22. For example, in the embodiment shown in FIG 2A, the first color filter 21 is a green color filter that allows green light to pass through. Of course, in other embodiments, the colors of the first color filter 21 and the second color filter 22 may also be other colors, as long as the light transmittance of the second color filter 22 is smaller than the light transmittance of the first color filter 21.

For example, the first sub-layer 221a is located on a side of the second sub-layer 221b close to the substrate 1; an orthographic projection of the first sub-layer 221a on the main surface 1a of the substrate 1 is located within an orthographic projection of the second sub-layer 221b on the main surface 1a of the substrate 1, and an area of the orthographic projection of the first sub-layer 221a on the main surface 1a of the substrate 1 is smaller than an area of the orthographic projection of the second sub-layer 221 b on the main surface 1a of the substrate 1. Therefore, the second sub-layer 221b farther away from the light-emitting device 3 further achieves a better effect of absorbing crosstalk light from adjacent pixels, and experiments have proved that this scheme is beneficial to achieve a better anti-crosstalk effect.

For example, in other embodiments, the number of the sub-layers of the second color filter 22 may be more than two, and in the embodiment shown in FIG 2A, the case that the number of the sub-layers of the second color filter 22 is two is taken as an example.

For example, the direction in which the first color filter 21 and the second color filter 22 are arranged is a lateral direction; a width of the first sub-layer 221a in the lateral direction is smaller than a width of the second sub-layer 221b in the lateral direction, so that at an edge of the entire second color filter 22, a region between an edge of the first sub-layer 221a and an edge of the second sub-layer 221b has a better anti-crosstalk effect in the lateral direction.

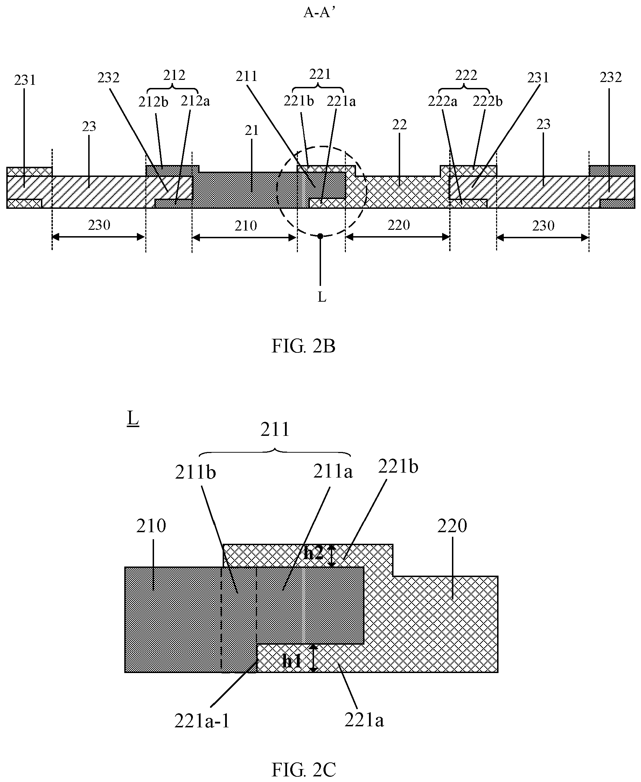

FIG 2C is an enlarged schematic diagram of a part L in FIG 2B. As shown in FIG 2C, for example, the first portion 211 of the first peripheral portion includes an inner portion 211a and an outer portion 211b. The inner portion 211a is sandwiched between the first sub-layer 221a and the second sub-layer 221b, and is overlapped with both the first sub-layer 221a and the second sub-layer 221b in the longitudinal direction; the outer portion 211b and the inner portion 211a constitute an integral structure, and the outer portion 211b is located on a side of the inner portion 211a close to the first light-transmitting portion 210 in the lateral direction, the outer portion 211b is not overlapped with the first sub-layer 221a, and is overlapped with the second sub-layer 221b in the longitudinal direction, therefore, at the edge of the entire second color filter 22, the region between the edge of the first sub-layer 221a and the edge of the second sub-layer 221b, that is, the position where the outer portion 211b is located, has a better anti-crosstalk effect in the lateral direction. For example, the outer portion 211b covers a side surface 221a-1 of the first sub-layer 221a and is in contact with the side surface 221a-1 of the first sub-layer 221a, the side surface 221a-1 of the first sub-layer 221a is intersected with the lateral direction, so that the structure is compact, which facilitates the realization of high PPI, and it is beneficial to enabling the bottom surface of the first color filter 21 close to the substrate 1 to be flush with the bottom surface of the second color filter 22 close to the substrate 1, and it is beneficial to improving the display uniformity of the entire display panel.

For example, the thickness h1 of the first sub-layer 221a of the second color filter 22 in the longitudinal direction is greater than the thickness h2 of the second sub-layer 221b of the second color filter 22 in the longitudinal direction. Experiments have proved that, the first sub-layer 221a with a larger thickness can achieve a better light blocking effect and prevent the problem of light crosstalk between the adjacent sub-pixels.

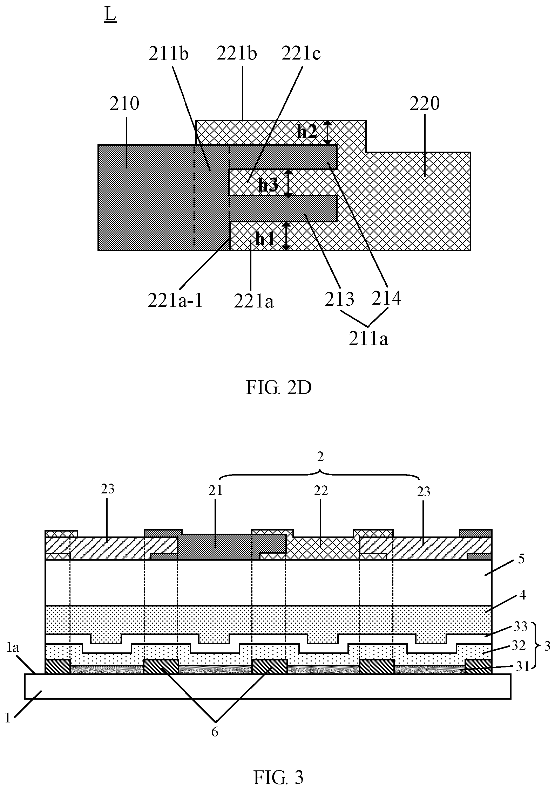

For example, FIG 2D is a partial enlarged diagram of the display panel provided by another embodiment at the same position L as in FIG 2B. As shown in FIG 2D, in the display panel provided by at least another embodiment, the first portion 211 of the first peripheral portion of the first color filter 21 also includes a plurality of sub-layers that are at least partially overlapped in the longitudinal direction and are spaced apart from each other in the longitudinal direction; the plurality of sub-layers of the first portion of the first peripheral portion and the plurality of sub-layers of the first portion of the second peripheral portion are alternately stacked in the longitudinal direction. For example, the inner portion 211a of the first portion 211 of the first color filter 21 includes a plurality of sub-layers that are at least partially overlapped in the longitudinal direction and spaced apart from each other in the longitudinal direction, For example, the inner portion 211a of the first portion 211 includes a first sub-layer 213 and a second sub-layer 214, the first sub-layer 213 and the second sub-layer 214 of the first color filter 21 and the first sub-layer 221a and the second sub-layer 221b of the second color filter 22 are alternately stacked in the longitudinal direction. In the present embodiment, the second color filter 22 with lower light transmittance and the first color filter 21 with lower light transmittance both include a plurality of sub-layers, and a better light blocking effect can be achieved, and the problem of light crosstalk between the adjacent sub-pixels can be prevented.

For example, in the embodiment shown in FIG 2D, the first portion 221 of the second peripheral portion of the second color filter 22 further includes a third sub-layer 221c. For example, the thickness h1 of the first sub-layer 221a of the second color filter 22 in the longitudinal direction and the thickness h3 of the third sub-layer 221c of the second color filter 22 in the longitudinal direction are both greater than the thickness h2 of the second sub-layer 221b of the second color filter 22 in the longitudinal direction. Or, in other embodiments, the plurality of sub-layers of the first portion 221 of the second peripheral portion of the second color filter 22 are arranged in the longitudinal direction, the thicknesses of the plurality of sub-layers in the longitudinal direction of the first portion 221 of the second peripheral portion gradually decrease in the direction from close to the substrate 1 to away from the substrate 1; that is, for example, in the embodiment shown in FIG 2D, the thickness h1 of the first sub-layer 221a in the longitudinal direction, the thickness h3 of the third sub-layer 221c in the longitudinal direction, and the thickness h2 of the second sub-layer 221b in the longitudinal direction gradually decrease.

For example, as shown in FIG 2D, among the plurality of sub-layers of the first portion 211 of the first peripheral portion of the first color filter 21 and the plurality of sub-layers of the first portion 221 of the second peripheral portion of the second color filter 22, the first sub-layer 221a is closest to the substrate 1, so that light from the light-emitting layer 32 first passes through the second color filter with the lower light transmittance in the non light-emitting region 04, then passes through the first color filter with the higher light transmittance, thereby a better light blocking effect can be achieved in the non light-emitting region 04, and the problem of light crosstalk between the adjacent sub-pixels can be better prevented.

Other features and corresponding technical effects of the display panel shown in FIG 2D are the same as those of the embodiment shown in FIG 2A to FIG 2C, which can be referred to the descriptions in the embodiments shown in FIG 2A to FIG 2C.

For example, as shown in FIG 2A, the display panel 10 further includes a thin film encapsulation layer 4, and the thin film encapsulation layer 4 covers the light-emitting devices of the plurality of sub-pixels in the entire display region. The display panel 10 further includes a flat layer 5, the flat layer 5 covers the main surface 1a of the substrate 1, for example, the flat layer 5 is located on a side of the thin film encapsulation layer 4 away from the substrate 1 and covers the thin film encapsulation layer 4, and the flat layer 5 has a flat surface away from the substrate 1, the first color filter 21 and the second color filter 22 are located on the flat surface, and the first sub-layer 221a of the second color filter 22 is in contact with the flat surface. For example, the bottom surface of the first color filter 21 close to the substrate 1 is flush with the bottom surface of the second color filter 22 close to the substrate 1, the bottom surfaces are both in contact with the flat surface, and it is beneficial to the display uniformity of the entire display panel.

For example, as shown in FIG 2B or FIG 2D, among the plurality of sub-layers of the first portion 211 of the first peripheral portion of the first color filter 21 and the plurality of sub-layers of the first portion 221 of the second peripheral portion of the first color filter 21, the second sub-layer 221b of the first portion 221 of the second peripheral portion of the second color filter 22 is farthest away from the substrate 1. In this way, it can be ensured that the path of the light from the light-emitting layer 32 in the non light-emitting region 04 finally passes through the second color filter 22 with the lower light transmittance, so that a better light blocking effect in the non light-emitting region 04 can be achieved, and the problem of light crosstalk between the adjacent sub-pixels can be better prevented.

For example, as shown in FIG 2A to FIG 2B, the color filter of the plurality of sub-pixels further includes a third color filter 23 which is adjacent to the second color filter 22 and located on a side of the second color filter 22 away from the first color filter 21, the light transmission colors of the first color filter 21, the second color filter 22 and the third color filter 23 are different from each other, and the light transmittance of the second color filter 22 is smaller than the light transmittance of the third color filter 23, that is, the light transmittance of the second color filter 22 is smaller than the light transmittance of the first color filter 21 and smaller than the light transmittance of the third color filter 23. The third color filter 23 includes a third light-transmitting portion 230 and a third peripheral portion. The third light-transmitting portion 230 is configured to allow the light of the sub-pixel where the third light-transmitting portion 230 is located to pass through to emit from the display panel 10; the third peripheral portion at least partially surrounds the third light-transmitting portion 230, and the third peripheral portion includes a first portion 231 located on a side of the third light-transmitting portion 230 close to the second color filter 22, a region where the third peripheral portion is located is a non light-emitting region (non-display region); the second peripheral portion further includes a second portion 232 located on a side of the second light-transmitting portion 220 close to the third color filter 23. The second portion 222 of the second peripheral portion includes a plurality of sub-layers that are at least partially overlapped in the longitudinal direction perpendicular to the main surface 1a of the substrate 1 and spaced apart from each other in the longitudinal direction, the plurality of sub-layers of the second portion 222 of the second peripheral portion include a third sub-layer 222a and a fourth sub-layer 222b, at least a part of the first portion 231 of the third peripheral portion is located between the third sub-layer 222a and the fourth sub-layer 222b in the longitudinal direction, similar to the relationship between the first portion 221 of the second peripheral portion and the first portion 211 of the first peripheral portion, for details, it can refer to the descriptions of the specific positional relationship between the first portion 221 of the second peripheral portion and the first portion 211 of the first peripheral portion, in this way, a similar light blocking effect and a technical effect of preventing the problem of light crosstalk between the adjacent sub-pixels can be achieved in the non-display region where the third sub-layer 222a and the fourth sub-layer 222b are stacked with the first portion 231 of the third peripheral portion.

For example, the third color filter 23 is a red color filter that allows red light to pass through, that is, in the display panel provided by at least one embodiment, the first color filter 21 is a green color filter that allows green light to pass through, the second color filter 22 is a blue color filter that allows blue light to pass through, and the third color filter 23 is a red color filter that allows red light to pass through. Of course, the color filters are not limited to the colors listed above, as long as the light transmittance of the second color filter 22 is smaller than the light transmittance of the first color filter 21, and is smaller than the light transmittance of the third color filter 23.

For example, the second color filter 22 is substantially axisymmetric with respect to the symmetry axis along the longitudinal direction, thus in various embodiments, the second portion 222 and the first portion 221 of the second peripheral portion of the second color filter 22 may have symmetrical structures with respect to the symmetry axis in the longitudinal direction. For example, the first peripheral portions and the third peripheral portions adjacent to each other are also substantially axisymmetric with respect to the symmetry axis in the longitudinal direction. In this way, a better light blocking effect can be achieved in the non-display regions 04 at both two ends of the second color filter 22 in the lateral direction, and the problem of light crosstalk between the adjacent sub-pixels can be better prevented.

For example, as shown in FIG 2A to 2B, a cross section of the second color filter 22 in the longitudinal direction is substantially in a shape of I, and, a middle region of the second color filter 22 on the surface away from the substrate 1 has a depression, to reduce the thickness of the part of the second color filter 22 in the light-emitting region (that is, the opening region) in the longitudinal direction, that is, the thickness of the second light-transmitting portion 220 in the longitudinal direction is reduced, so that the problem that the thickness of the second light-transmitting portion 220 is increased which problem is caused by the second color filter 22 having a plurality of stacked sub-layers is avoided, and thus it is avoided that the thickness of the second light-transmitting part 220 is large, which affects the light transmittance. For example, in the display panel provided by the embodiment of the present disclosure, with reference to FIG 1, one first color filter 21, one second color filter 22 and one third color filter 23 that are arranged in sequence constitute a repeating unit, and a plurality of repeating units are repeatedly arranged to provide one color filter for each of the plurality of sub-pixels 01/02/03.

For example, as shown in FIG 2A to FIG 2B, in one repeating unit, the first peripheral portion of the first color filter 21 further includes a second portion 212 located on a side of the first transparent portion 210 away from the second color filter 22, and the third peripheral portion further includes a second portion 232 located on a side of the third light-transmitting portion close to the first color filter 21 of the adjacent repeating unit. The second portion 212 of the first peripheral portion comprises a plurality of sub-layers that are at least partially overlapped in the longitudinal direction perpendicular to the main surface 1a of the substrate 1 and are spaced apart from each other in the longitudinal direction, for example, the plurality of sub-layers of the first peripheral portion include a fifth sub-layer 212a and a sixth sub-layer 212b, at least a part of the second portion 232 of the third peripheral portion of the third color filter 23 in the repeating unit adjacent to the one repeating unit is located between the fifth sub-layer 212a and the sixth sub-layer 212b in the longitudinal direction. Therefore, a better light blocking effect is achieved in the non light-emitting region 04 where the second portion 212 of the first peripheral portion and the second portion 232 of the third peripheral portion are overlapped, and the problem of light crosstalk between adjacent sub-pixels can be better prevented.

For example, in one repeating unit, the shape and the size of the second portion 212 of the first peripheral portion are respectively substantially the same as the shape and the size of the first portion 221 of the second peripheral portion; the shape and the size of the second portion 232 of the third peripheral portion are respectively substantially the same as the shape and the size of the first portion 211 of the first peripheral portion, so that the same or similar technical effects as the above-mentioned features related to the first portion 221 of the second peripheral portion and the features related to the first portion 211 of the first peripheral portion are achieved, therefore, the related features of the shape and the size of the second portion 212 of the first peripheral portion, and the related features of the shape and the size of the second portion 232 of the third peripheral portion are not repeated herein, which can refer to the previous descriptions of the features related to the first portion 221 of the second peripheral portion and the features related to the first portion 211 of the first peripheral portion.

For example, as shown in FIG 2A to FIG 2B, in an upper surface of the first color filter 21 away from the substrate 1, a position where the second portion 212 of the first peripheral portion borders the first light-transmitting portion 210 has a stepped structure to reduce the thickness of the first light-transmitting portion 210 in the longitudinal direction, so that the problem that the thickness of the first light-transmitting portion 210 is increased which problem is caused by the first color filter 21 having a plurality of stacked sub-layers is avoided, and thus it is avoided that the thickness of the first light-transmitting portion 210 is large, which affects the light transmittance.

For example, as shown in FIG 2A to FIG 2B, a cross-sectional shape of the third color filter 23 in the longitudinal direction is in a shape of T.

For example, in at least one embodiment shown in FIG 3, the display panel 10 further includes a pixel definition layer 6, the pixel definition layer 6 defines openings for the plurality of sub-pixels of the pixel array, the light-emitting devices are at least partially located in the openings; orthographic projections of the first light-transmitting portion 210, the second light-transmitting portion 220 and the third light-transmitting portion 230 on the main surface 1a of the substrate 1 are respectively located in orthographic projections of the openings of the sub-pixels corresponding to the first color filter 21, the second color filter 22 and the third color filter 23 on the main surface 1a of the substrate 1, and orthographic projections of the first peripheral portion, the second peripheral portion and the third peripheral portion on the main surface 1a of the substrate 1 are all located within an orthographic projection of the pixel definition layer 6 on the main surface 1a of the substrate 1, to maximize the aperture ratio of the display panel 10. In this case, for example, the substrate 1 is a glass substrate, a quartz substrate, or a flexible substrate, and display apparatus such as pixel circuits are manufactured on the substrate 1 by using a semiconductor process.

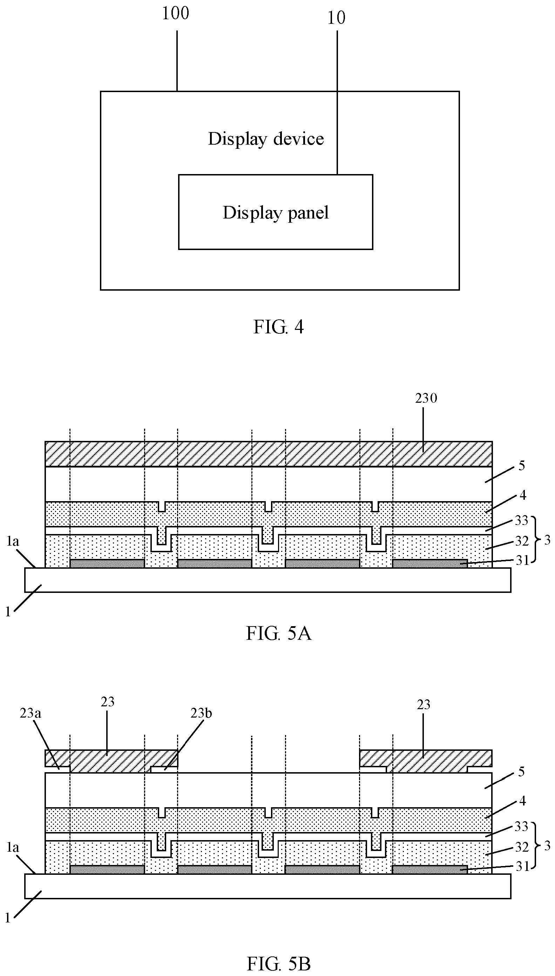

For example, at least one embodiment of the present disclosure further provides a display apparatus 100, as shown in FIG 4, the display apparatus includes any one of the display panels 10 provided in the embodiments of the present disclosure.

FIG 5A to FIG 5D are schematic diagrams of a manufacturing method of a display panel provided by at least one embodiment of the present disclosure, for example, are schematic diagrams of the manufacturing method of the display panel shown in FIG 1A. For example, in at least one embodiment, the display panel may be manufactured in an order of FIG 5A to FIG 5D.

As shown in FIG 5A, a substrate 1 is provided, for example, the substrate 1 is a silicon-based substrate; the display panel 10 is encapsulated to form the above-mentioned thin film encapsulation layer 4; and a flat layer 5 is formed on the thin film encapsulation layer 4; and a third color filter material layer 23 is formed on the flat layer 5.

As shown in FIG 5B, a patterning process is performed on a third color filter material layer 23 to form the third color filter 23, and a first notch 23a and a second notch 23b are respectively formed on a side of two ends of the third color filter 23 close to the substrate 1; the specific structural features of the third color filter 23 may be referred to the descriptions of the embodiment shown in FIG 1A.

For example, the patterning process is an exposure-development process. An exposure machine may be used to determine the positions where the first notch 23a and the second notch 23b are located as focus positions, the exposure value is arranged to a suitable negative value, the first notch 23a and the second notch 23b can be formed after performing the developing process on the exposed third color filter material layer 23, and the third color filter 23 as shown in 5B is obtained. Specifically, those skilled in the art can use conventional techniques in the art to achieve the third color filter 23.

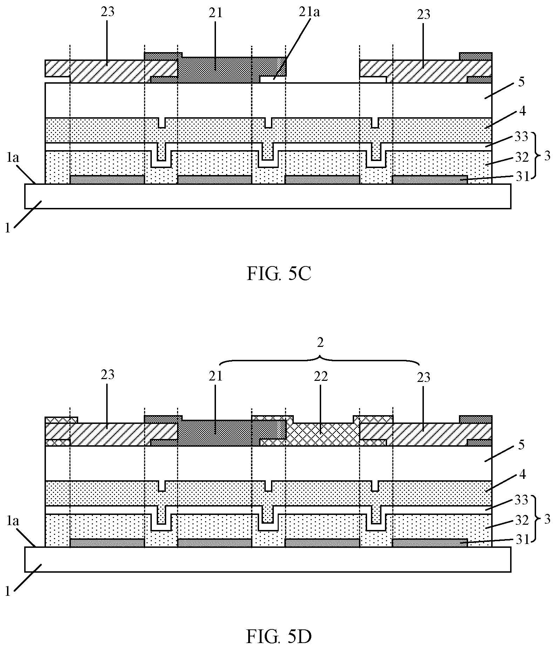

As shown in FIG 5C, a first color filter material is coated to form a first color filter material layer, the first color filter material is filled in the first notch 23a but not filled in the second notch 23b, for example, a spin coating method may be used to fill the first color filter material into the first notch 23a, similarly, an exposure method similar to that performed on the third color filter material layer 23 is performed on the first color filter material layer, the first color filter 21 shown in FIG 5C can be formed after developing, and a side of the first color filter close to the substrate 1 away from the end of the third color filter 23 in contact with the first color filter has a third notch 21a.

As shown in FIG 5D, a second color filter material is coated to form a second color filter material layer, and the second color filter material is filled in the second notch 23b and the third notch 21a; for example, the second color filter material layer covers the plurality of sub-pixels in the display region, for example, covers the first color filter 22 and the third color filter 23, and a patterning process is performed on the second color filter material layer to obtain the second color filter 22 shown in FIG 5D. For the specific structural features of the second color filter 22 corresponding to one of the sub-pixels, it can refer to the descriptions in the previous embodiments, which are not repeated herein.

What are described above is related to only the illustrative embodiments of the present disclosure and not limitative to the protection scope of the present application. Therefore, the protection scope of the present application shall be defined by the accompanying claims.

## Claims

1. A display panel (10), comprising:
a substrate (1), comprising a main surface (1a);
a plurality of sub-pixels (01, 02, 03), arranged in an array on the main surface (1a) of the substrate (1), wherein each of the plurality of sub-pixels (01, 02, 03) comprises a light-emitting device (3) and a color filter (21, 22, 23) on a light-emitting side of the light-emitting device (3); the color filter of the plurality of sub-pixels (01, 02, 03) comprises a first color filter (21) and a second color filter (22) that are adjacent, light transmission color of the first color filter (21) and light transmission color of the second color filter (22) are different from each other, and light transmittance of the second color filter (22) is smaller than light transmittance of the first color filter (21);
the first color filter (21) comprises a first light-transmitting portion (210) and a first peripheral portion, the first light-transmitting portion (210) is configured to allow light of the sub-pixel where the first light-transmitting portion (210) is located to pass through to emit from the display panel (10); the first peripheral portion at least partially surrounds the first light-transmitting portion (210), and comprises a first portion (211) located on a side of the first light-transmitting portion (210) close to the second color filter (22);
the second color filter (22) comprises a second light-transmitting portion (220) and a second peripheral portion, the second light-transmitting portion (220) is configured to allow light of the sub-pixel where the second light-transmitting portion (220) is located to pass through to emit from the display panel (10); the second peripheral portion at least partially surrounds the second light-transmitting portion (220), and comprises a first portion (221) located on a side of the second light-transmitting portion (220) close to the first color filter (21);
the first portion (221) of the second peripheral portion comprises a plurality of sub-layers that are at least partially overlapped and spaced apart from each other in a longitudinal direction perpendicular to the main surface (1a) of the substrate (1), the plurality of sub-layers comprise a first sub-layer (221a) and a second sub-layer (221b), and at least a part of the first portion (211) of the first peripheral portion is located between the first sub-layer (221a) and the second sub-layer (221b) in the longitudinal direction;
the first portion (211) of the first peripheral portion comprises an inner portion (211a),
the first sub-layer (221a) is on a side of the second sub-layer (221b) close to the substrate (1);
a direction in which the first color filter (21) and the second color filter (22) are arranged is a lateral direction; **characterized in that**:
the inner portion (211a) is sandwiched between the first sub-layer (221a) and the second sub-layer (221b), wherein the inner portion (211a) is overlapped with both the first sub-layer (221a) and the second sub-layer (221b) in the longitudinal direction; the first sub-layer (221a) covers and contacts a surface of the inner portion (211a) facing the substrate (1), and the second sub-layer (221b) covers and contacts a surface of the inner portion (211a) away from the substrate (1);
an orthographic projection of the first sub-layer (221a) on the main surface (1a) of the substrate (1) is within an orthographic projection of the second sub-layer (221b) on the main surface (1a) of the substrate (1), and an area of the orthographic projection of the first sub-layer (221a) on the main surface (1a) of the substrate (1) is smaller than an area of the orthographic projection of the second sub-layer (221b) on the main surface (1a) of the substrate (1); and
a width of the first sub-layer (221a) in the lateral direction is smaller than a width of the second sub-layer (221b) in the lateral direction.

2. The display panel (10) according to claim 1, wherein the second color filter (22) is a blue color filter that allows blue light to pass through.

3. The display panel (10) according to claim 1, wherein the first portion (211) of the first peripheral portion further comprises an outer portion (211b), the outer portion (211b) is integral with the inner portion (211a) and on a side of the inner portion (211a) close to the first light-transmitting portion (210) in the lateral direction, wherein the outer portion (211b) is not overlapped with the first sub-layer (221a), and is overlapped with the second sub-layer (221b) in the longitudinal direction.

4. The display panel (10) according to claim 3, wherein the outer portion (211b) covers a side surface (221a-1) of the first sub-layer (221a) and is in contact with the side surface (221a-1) of the first sub-layer (221a), and the side surface (221a-1) of the first sub-layer (221a) is intersected with the lateral direction.

5. The display panel (10) according to any one of claims 1 to 4, wherein the first sub-layer (221a) is on a side of the second sub-layer (221b) close to the substrate (1); and
a thickness of the first sub-layer (221a) in the longitudinal direction is greater than a thickness of the second sub-layer (221b) in the longitudinal direction.

6. The display panel (10) according to any one of claims 1 to 5, wherein the first portion (211) of the first peripheral portion comprises a plurality of sub-layers that are at least partially overlapped in the longitudinal direction and are spaced apart from each other in the longitudinal direction; and
the plurality of sub-layers of the first portion (211) of the first peripheral portion and the plurality of sub-layers of the first portion (221) of the second peripheral portion are alternately stacked in the longitudinal direction.

7. The display panel (10) according to claim 6, wherein among the plurality of sub-layers of the first portion (211) of the first peripheral portion and the plurality of sub-layers of the first portion (221) of the second peripheral portion, the first sub-layer is closest to the substrate (1);
the display panel (10) further comprises:
a flat layer (5), covering the main surface (1a) of the substrate (1), and having a flat surface away from the substrate (1), wherein the first color filter (21) and the second color filter (22) are located on the flat surface, and the first sub-layer (221a) is in contact with the flat surface.

8. The display panel (10) according to claim 6, wherein among the plurality of sub-layers of the first portion (211) of the first peripheral portion and the plurality of sub-layers of the first portion (221) of the second peripheral portion, the second sub-layer (221b) is farthest away from the substrate (1).

9. The display panel (10) according to any one of claims 6 to 8, wherein the plurality of sub-layers of the first portion (221) of the second peripheral portion are arranged in the longitudinal direction, and in a direction from close to the substrate (1) to away from the substrate (1), thicknesses of the plurality of sub-layers in the longitudinal direction of the first portion (221) of the second peripheral portion gradually decrease.

10. The display panel (10) according to any one of claims 6 to 9, wherein a direction in which the first color filter (21) and the second color filter (22) are arranged is a lateral direction;
the plurality of sub-layers of the first portion (221) of the second peripheral portion are arranged in the longitudinal direction, in a direction from close to the substrate (1) to away from the substrate (1), widths of the plurality of sub-layers of the first portion (221) of the second peripheral portion in the lateral direction gradually increase.

11. The display panel (10) according to any one of claims 1 to 10, wherein the color filter of the plurality of sub-pixels (01, 02, 03) further comprises a third color filter (23) adjacent to the second color filter (22) and on a side of the second color filter (22) away from the first color filter (21), light transmission colors of the first color filter (21), the second color filter (22) and the third color filter (23) are different from each other, the light transmittance of the second color filter (22) is smaller than a light transmittance of the third color filter (23);
the third color filter (23) comprises a third light-transmitting portion (230) and a third peripheral portion, the third light-transmitting portion (230) is configured to allow light of the sub-pixel where the third light-transmitting portion (230) is located to pass through to emit from the display panel (10); the third peripheral portion at least partially surrounds the third light-transmitting portion (230), and the third peripheral portion comprises a first portion (231) on a side of the third light-transmitting portion (230) close to the second color filter (22);
the second peripheral portion further comprises a second portion (222) on a side of the second light-transmitting portion (220) close to the third color filter (23);
the second portion (222) of the second peripheral portion comprises a plurality of sub-layers that are at least partially overlapped in the longitudinal direction perpendicular to the main surface (1a) of the substrate (1) and are spaced apart from each other in the longitudinal direction, the plurality of sub-layers of the second portion (222) of the second peripheral portion comprises a third sub-layer (222a) and a fourth sub-layer (222b), and at least a part of the first portion (231) of the third peripheral portion is between the third sub-layer (222a) and the fourth sub-layer (222b) in the longitudinal direction;
the first color filter (21) is a green color filter that allows green light to pass through, and the third color filter (23) is a red color filter that allows red light to pass through.

12. The display panel (10) according to any one of claims 1 to 10, wherein the color filter of the plurality of sub-pixels (01, 02, 03) further comprises a third color filter (23) adjacent to the second color filter (22) and on a side of the second color filter (22) away from the first color filter (21), light transmission colors of the first color filter (21), the second color filter (22) and the third color filter (23) are different from each other, the light transmittance of the second color filter (22) is smaller than a light transmittance of the third color filter (23);
the third color filter (23) comprises a third light-transmitting portion (230) and a third peripheral portion, the third light-transmitting portion (230) is configured to allow light of the sub-pixel where the third light-transmitting portion (230) is located to pass through to emit from the display panel (10); the third peripheral portion at least partially surrounds the third light-transmitting portion (230), and the third peripheral portion comprises a first portion (231) on a side of the third light-transmitting portion (230) close to the second color filter (22);
the second peripheral portion further comprises a second portion (222) on a side of the second light-transmitting portion (220) close to the third color filter (23);
the second portion (222) of the second peripheral portion comprises a plurality of sub-layers that are at least partially overlapped in the longitudinal direction perpendicular to the main surface (1a) of the substrate (1) and are spaced apart from each other in the longitudinal direction, the plurality of sub-layers of the second portion (222) of the second peripheral portion comprises a third sub-layer (222a) and a fourth sub-layer (222b), and at least a part of the first portion (231) of the third peripheral portion is between the third sub-layer (222a) and the fourth sub-layer (222b) in the longitudinal direction;
the second color filter (22) is substantially axisymmetric with respect to a symmetry axis along the longitudinal direction, and the first peripheral portion and the third peripheral portion are substantially axisymmetric with respect to the symmetry axis; and
a cross section of the second color filter (22) in the longitudinal direction is substantially in a shape of I.

13. The display panel (10) according to any one of claims 11 to 12, wherein one of the first color filter (21), one of the second color filter (22), and one of the third color filter (23) which are sequentially arranged in sequence constitute a repeating unit, and a plurality of the repeating units are repeatedly arranged to provide one of the color filter for each of the plurality of sub-pixels (01, 02, 03);
in one of the repeating units, the first peripheral portion further comprises a second portion (212) on a side of the first light-transmitting portion (210) away from the second color filter (22), and the third peripheral portion further comprises a second portion (212) on a side of the third light-transmitting portion (230) close to the first color filter (21) of an adjacent repeating unit; and
the second portion (212) of the first peripheral portion comprises a plurality of sub-layers that are at least partially overlapped in the longitudinal direction perpendicular to the main surface (1a) of the substrate (1) and are spaced apart from each other in the longitudinal direction, the plurality of sub-layers of the second portion (212) of the first peripheral portion comprise a fifth sub-layer (212a) and a sixth sub-layer (212b), and at least a part of a second portion (232) of the third peripheral portion of the third color filter (23) in the repeating unit adjacent to the one of the repeating units is located between the fifth sub-layer (212a) and the sixth sub-layer (212b) in the longitudinal direction;
in one of the repeating units, a shape and a size of the second portion (212) of the first peripheral portion are same as a shape and a size of the first portion (221) of the second peripheral portion, respectively;
a shape and a size of the second portion (232) of the third peripheral portion are respectively same as a shape and a size of the first portion (212) of the first peripheral portion; and
a cross section of the third color filter (23) in the longitudinal direction is in a shape of T.

14. A display apparatus (100), comprising the display panel (10) according to any one of claims 1 to 13.

## Patentansprüche

1. Anzeigetafel (10), umfassend:
ein Substrat (1) umfassend eine Hauptoberfläche (1a);
eine Vielzahl von Subpixeln (01, 02, 03), die in einem Array auf der Hauptoberfläche (1a) des Substrats (1) angeordnet sind, wobei jedes von der Vielzahl von Subpixeln (01, 02, 03) eine lichtemittierende Vorrichtung (3) und einen Farbfilter (21, 22, 23) auf einer lichtemittierenden Seite der lichtemittierenden Vorrichtung (3) umfasst; wobei der Farbfilter der Vielzahl von Unterpixeln (01, 02, 03) einen ersten Farbfilter (21) und einen zweiten Farbfilter (22), die benachbart sind, umfasst, wobei sich die Lichtdurchlässigkeitsfarbe des ersten Farbfilters (21) und die Lichtdurchlässigkeitsfarbe des zweiten Farbfilters (22) voneinander unterscheiden und die Lichtdurchlässigkeit des zweiten Farbfilters (22) kleiner als die Lichtdurchlässigkeit des ersten Farbfilters (21) ist;
der erste Farbfilter (21) einen ersten lichtdurchlässigen Abschnitt (210) und einen ersten Randabschnitt umfasst, wobei der erste lichtdurchlässige Abschnitt (210) konfiguriert ist, um Licht des Subpixels, wo sich der erste lichtdurchlässige Abschnitt (210) befindet, zu erlauben durchzugelangen, um aus der Anzeigetafel (10) auszutreten; der erste Randbereich zumindest teilweise den ersten lichtdurchlässigen Bereich (210) umgibt und einen ersten Abschnitt (211) umfasst, der sich auf einer Seite des ersten lichtdurchlässigen Abschnitts (210) nahe zu dem zweiten Farbfilter (22) befindet;
der zweite Farbfilter (22) einen zweiten lichtdurchlässigen Abschnitt (220) und einen zweiten Randbereich umfasst, wobei der zweite lichtdurchlässige Abschnitt (220) konfiguriert ist, um Licht des Subpixels, wo sich der zweite lichtdurchlässige Abschnitt (220) befindet, zu erlauben, durchzugelangen, um aus dem Anzeigefeld (10) auszutreten; der zweite Randbereich zumindest teilweise den zweiten lichtdurchlässigen Abschnitt (220) umgibt und einen ersten Abschnitt (221) umfasst, der sich auf einer Seite des zweiten lichtdurchlässigen Abschnitts (220) nahe zu dem ersten Farbfilter (21) befindet;
der erste Abschnitt (221) des zweiten Randabschnitts eine Vielzahl von Sub-Schichten umfasst, die zumindest teilweise überlappt sind und in einer Längsrichtung senkrecht zu der Hauptoberfläche (1a) des Substrats (1) voneinander beabstandet sind, die Vielzahl von Sub-Schichten eine erste Sub-Schicht (221a) und eine zweite Sub-Schicht (221b) umfassen, und mindestens ein Teil des ersten Abschnitts (211) des ersten Randabschnitts in der Längsrichtung zwischen der ersten Sub-Schicht (221a) und der zweiten Sub-Schicht (221b) angeordnet ist;
der erste Abschnitt (211) des ersten Randabschnitts einen inneren Abschnitt (211a) umfasst,
die erste Sub-Schicht (221a) sich auf einer Seite der zweiten Sub-Schicht (221b) nahe zu dem Substrat (1) befindet;
eine Richtung, in der der erste Farbfilter (21) und der zweite Farbfilter (22) angeordnet sind, eine seitliche Richtung ist; **dadurch gekennzeichnet, dass**:
der innere Abschnitt (211a) sandwichartig zwischen der ersten Sub-Schicht (221a) und der zweiten Sub-Schicht (221b) angeordnet ist, wobei der innere Abschnitt (211a) sowohl mit der ersten Sub-Schicht (221a) als auch mit der zweiten Sub-Schicht (221b) in der Längsrichtung überlappt ist; die erste Sub-Schicht (221a) eine dem Substrat (1) zugewandte Oberfläche des inneren Abschnitts (211a) bedeckt und mit dieser in Kontakt steht, und die zweite Sub-Schicht (221b) eine vom Substrat (1) entfernte Oberfläche des inneren Abschnitts (211a) bedeckt und mit dieser in Kontakt steht ;
eine orthogonale Projektion der ersten Sub-Schicht (221a) auf die Hauptoberfläche (1a) des Substrats (1) innerhalb einer orthogonalen Projektion der zweiten Sub-Schicht (221b) auf die Hauptoberfläche (1a) des Substrats (1) ist, und ein Bereich der orthogonalen Projektion der ersten Sub-Schicht (221a) auf die Hauptoberfläche (1a) des Substrats (1) kleiner ist als ein Bereich der orthogonalen Projektion der zweiten Sub-Schicht (221b) auf die Hauptoberfläche (1a) des Substrats (1); und
eine Breite der ersten Sub-Schicht (221a) in der seitlichen Richtung kleiner ist als eine Breite der zweiten Sub-Schicht (221b) in der seitlichen Richtung.

2. Anzeigetafel (10) gemäß Anspruch 1, wobei der zweite Farbfilter (22) ein blauer Farbfilter ist, der blauem Licht erlaubt, durchzugelangen.

3. Anzeigetafel (10) gemäß Anspruch 1, wobei der erste Abschnitt (211) des ersten Randabschnitts außerdem einen äußeren Abschnitt (211b) umfasst, wobei der äußere Abschnitt (211b) einstückig mit dem inneren Abschnitt (211a) ausgebildet ist und auf einer Seite des inneren Abschnitts (211a) nahe zu dem ersten lichtdurchlässigen Abschnitt (210) in der seitlichen Richtung ist, wobei der äußere Abschnitt (211b) nicht mit der ersten Sub-Schicht (221a) überlappt ist und in der Längsrichtung mit der zweiten Sub-Schicht (221b) überlappt ist.

4. Anzeigetafel (10) gemäß Anspruch 3, wobei der äußere Abschnitt (211b) eine Seitenfläche (221a-1) der ersten Sub-Schicht (221a) bedeckt und mit der Seitenfläche (221a-1) der ersten Sub-Schicht (221a) in Kontakt steht, und die Seitenfläche (221a-1) der ersten Sub-Schicht (221a) mit der lateralen Richtung schneidet.

5. Anzeigetafel (10) gemäß einem der Ansprüche 1 bis 4, wobei die erste Sub-Schicht (221a) auf einer Seite der zweiten Sub-Schicht (221b) nahe zu dem Substrat (1; und
eine Dicke der ersten Sub-Schicht (221a) in der Längsrichtung größer ist als eine Dicke der zweiten Sub-Schicht (221b) in der Längsrichtung.

6. Anzeigetafel (10) gemäß einem der Ansprüche 1 bis 5, wobei der erste Abschnitt (211) des ersten Randabschnitts eine Vielzahl von Sub-Schichten umfasst, die in der Längsrichtung zumindest teilweise überlappt sind und in der Längsrichtung voneinander beabstandet sind; und
die Vielzahl von Sub-Schichten des ersten Abschnitts (211) des ersten Randabschnitts und die Vielzahl von Sub-Schichten des ersten Abschnitts (221) des zweiten Randabschnitts in der Längsrichtung abwechselnd gestapelt sind.

7. Anzeigetafel (10) gemäß Anspruch 6, wobei unter der Vielzahl von Sub-Schichten des ersten Abschnitts (211) des ersten Randabschnitts und der Vielzahl von Sub-Schichten des ersten Abschnitts (221) des zweiten Randabschnitts die erste Sub-Schicht dem Substrat (1) am nächsten ist;
die Anzeigetafel (10) außerdem umfasst:
eine flache Schicht (5), die die Hauptfläche (1a) des Substrats (1) bedeckt und eine von dem Substrat (1) entfernte flache Oberfläche aufweist, wobei sich der erste Farbfilter (21) und der zweite Farbfilter (22) auf der flachen Oberfläche befinden und die erste Sub-Schicht (221a) mit der flachen Oberfläche in Kontakt steht.

8. Anzeigetafel (10) gemäß Anspruch 6, wobei unter der Vielzahl von Sub-Schichten des ersten Abschnitts (211) des ersten Randabschnitts und der Vielzahl von Sub-Schichten des ersten Abschnitts (221) des zweiten Randabschnitts die zweite Sub-Schicht (221b) am weitesten von dem Substrat (1) entfernt ist.

9. Anzeigetafel (10) gemäß einem der Ansprüche 6 bis 8, wobei die Vielzahl von Sub-Schichten des ersten Abschnitts (221) des zweiten Randabschnitts in der Längsrichtung und in einer Richtung von nahe zu dem Substrat (1) zu entfernt von dem Substrat (1) angeordnet sind, wobei Dicken der Vielzahl von Sub-Schichten in der Längsrichtung des ersten Abschnitts (221) des zweiten Randabschnitts allmählich abnehmen.

10. Anzeigetafel (10) gemäß einem der Ansprüche 6 bis 9, wobei die Richtung, in der der erste Farbfilter (21) und der zweite Farbfilter (22) angeordnet sind, eine seitliche Richtung ist;
die Vielzahl von Sub-Schichten des ersten Abschnitts (221) des zweiten Randabschnitts in der Längsrichtung in einer Richtung von nahe zu dem Substrat (1) bis entfernt von dem Substrat (1) angeordnet sind, Breiten von der Vielzahl von Sub-Schichten des ersten Abschnitts (221) des zweiten Randabschnitts in der seitlichen Richtung allmählich zunehmen.

11. Anzeigetafel (10) gemäß einem der Ansprüche 1 bis 10, wobei der Farbfilter der Vielzahl von Subpixeln (01, 02, 03) außerdem einen dritten Farbfilter (23) umfasst, der benachbart zu dem zweiten Farbfilter (22) und auf einer Seite des zweiten Farbfilters (22) ist, die von dem ersten Farbfilter (21) entfernt ist, Lichtdurchlässigkeitsfarben des ersten Farbfilters (21), des zweiten Farbfilters (22) und des dritten Farbfilters (23) voneinander verschieden sind, die Lichtdurchlässigkeit des zweiten Farbfilters (22) kleiner ist als eine Lichtdurchlässigkeit des dritten Farbfilters (23);
der dritte Farbfilter (23) einen dritten lichtdurchlässigen Abschnitt (230) und einen dritten Randabschnitt umfasst, wobei der dritte lichtdurchlässige Abschnitt (230) konfiguriert ist, um Licht des Subpixels, wo sich der dritte lichtdurchlässige Abschnitt (230) befindet, zu erlauben, durchzugelangen, um aus der Anzeigetafel (10) auszutreten; der dritte Randabschnitt zumindest teilweise den dritten lichtdurchlässigen Abschnitt (230) umgibt, und der dritte Randabschnitt einen ersten Abschnitt (231) auf einer Seite des dritten lichtdurchlässigen Abschnitts (230) nahe zu dem zweiten Farbfilter (22) umfasst;
der zweite Randabschnitt außerdem einen zweiten Abschnitt (222) auf einer Seite des zweiten lichtdurchlässigen Abschnitts (220) nahe zu dem dritten Farbfilter (23) umfasst;
der zweite Abschnitt (222) des zweiten Randabschnitts eine Vielzahl von Sub-Schichten umfasst, die zumindest teilweise in der Längsrichtung senkrecht zu der Hauptoberfläche (1a) des Substrats (1) überlappt sind und in der Längsrichtung voneinander beabstandet sind, die Vielzahl von Sub-Schichten des zweiten Abschnitts (222) des zweiten Randabschnitts eine dritte Sub-Schicht (222a) und eine vierte Sub-Schicht (222b) umfassen, und mindestens ein Teil des ersten Abschnitts (231) des dritten Randabschnitts in der Längsrichtung zwischen der dritten Sub-Schicht (222a) und der vierten Sub-Schicht (222b) ist;
der erste Farbfilter (21) ein grüner Farbfilter ist, der grünem Licht erlaubt, durchzugelangen, und der dritte Farbfilter (23) ein roter Farbfilter ist, der rotem Licht erlaubt, durchzugelangen.

12. Anzeigetafel (10) gemäß einem der Ansprüche 1 bis 10, wobei der Farbfilter der Vielzahl von Subpixeln (01, 02, 03) außerdem einen dritten Farbfilter (23) umfasst, der benachbart zu dem zweiten Farbfilter (22) und auf einer Seite des zweiten Farbfilters (22) ist, die von dem ersten Farbfilter (21) entfernt ist, Lichtdurchlässigkeitsfarben des ersten Farbfilters (21), des zweiten Farbfilters (22) und des dritten Farbfilters (23) voneinander verschieden sind, die Lichtdurchlässigkeit des zweiten Farbfilters (22) kleiner ist als die Lichtdurchlässigkeit des dritten Farbfilters (23);
der dritte Farbfilter (23) einen dritten lichtdurchlässigen Abschnitt (230) und einen dritten Randabschnitt umfasst, wobei der dritte lichtdurchlässige Abschnitt (230) konfiguriert ist, um Licht des Subpixels, wo sich der dritte lichtdurchlässige Abschnitt (230) befindet, zu erlauben, durchzugelangen, um aus der Anzeigetafel (10) auszutreten; der dritte Randabschnitt zumindest teilweise den dritten lichtdurchlässigen Abschnitt (230) umgibt auf einer Seite des dritten lichtdurchlässigen Abschnitts (230), nahe zu dem zweiten Farbfilter (22);
der zweite Randabschnitt außerdem einen zweiten Abschnitt (222) umfasst auf einer Seite des zweiten lichtdurchlässigen Abschnitts (220) nahe zu dem dritten Farbfilter (23);
der zweite Abschnitt (222) des zweiten Randabschnitts eine Vielzahl von Sub-Schichten umfasst, die zumindest teilweise in der Längsrichtung senkrecht zu der Hauptoberfläche (1a) des Substrats (1) überlappt sind und in der Längsrichtung voneinander beabstandet sind, wobei die Vielzahl von Sub-Schichten des zweiten Abschnitts (222) des zweiten Randabschnitts eine dritte Sub-Schicht (222a) und eine vierte Sub-Schicht (222b) umfasst und zumindest ein Teil des ersten Abschnitts (231) des dritten Randabschnitts in der Längsrichtung zwischen der dritten Sub-Schicht (222a) und der vierten Sub-Schicht (222b)ist;
der zweite Farbfilter (22) im Wesentlichen achsensymmetrisch in Bezug auf eine Symmetrieachse entlang der Längsrichtung ist, und der erste Randabschnitt und der dritte Randabschnitt im Wesentlichen achsensymmetrisch in Bezug auf die Symmetrieachse sind; und
ein Querschnitt des zweiten Farbfilters (22) in der Längsrichtung im Wesentlichen die Form eines I hat.

13. Anzeigetafel (10) gemäß einem der Ansprüche 11 bis 12, wobei einer von dem ersten Farbfilter (21) und einer von dem zweiten Farbfilter (22) und einer von dem dritten Farbfilter (23), die sequentiell angeordnet sind, eine sich wiederholende Einheit bilden, und eine Vielzahl, der sich wiederholenden Einheiten wiederholt angeordnet sind, um einen der Farbfilter für jedes von der Vielzahl von Subpixeln (01, 02, 03) bereitzustellen;
in einer der sich wiederholenden Einheiten des ersten Randabschnitts außerdem einen zweiten Abschnitt (212) auf einer Seite des ersten lichtdurchlässigen Abschnitts (210) umfasst, die von dem zweiten Farbfilter (22) entfernt ist, und der dritte Randabschnitt außerdem einen zweiten Abschnitt (212) umfasst auf einer Seite des dritten lichtdurchlässigen Abschnitts (230) nahe dem ersten Farbfilter (21) einer benachbarten sich wiederholenden Einheit; und
der zweite Abschnitt (212) des ersten Randabschnitts eine Vielzahl von
Sub-Schichten umfasst, die zumindest teilweise in der Längsrichtung senkrecht zu der Hauptoberfläche (1a) des Substrats (1) überlappt sind und in der Längsrichtung voneinander beabstandet sind, wobei die Vielzahl von Sub-Schichten des zweiten Abschnitts (212) des ersten Randabschnitts eine fünfte Sub-Schicht (212a) und eine sechste Sub-Schicht (212b) umfassen, und mindestens ein Teil eines zweiten Abschnitts (232) des dritten Randabschnitts des dritten Farbfilters (23) in der sich wiederholenden Einheit, die zu der einen sich wiederholenden Einheit benachbart ist, sich in der Längsrichtung zwischen der fünften Sub-Schicht (212a) und der sechsten Sub-Schicht (212b) befindet;
in einer der sich wiederholenden Einheiten eine Form und eine Größe des zweiten Abschnitts (212) des ersten Randabschnitts gleich der Form bzw. der Größe des ersten Abschnitts (221) des zweiten Randabschnitts sind;
eine Form und eine Größe des zweiten Abschnitts (232) des dritten Randabschnitts gleich wie eine Form bzw. eine Größe des ersten Abschnitts (212) des ersten Randabschnitts sind;
und ein Querschnitt des dritten Farbfilters (23) in der Längsrichtung die Form T hat.

14. Anzeigevorrichtung (100) umfassend, die Anzeigetafel (10) gemäß einem der Ansprüche 1 bis 13.

## Revendications

1. Panneau d'affichage (10), comprenant :
un substrat (1), comprenant une surface principale (1a) ;
une pluralité de sous-pixels (01, 02, 03), agencés dans une matrice sur la surface principale (1a) du substrat (1), dans lequel chacun de la pluralité de sous-pixels (01, 02, 03) comprend un dispositif électroluminescent (3) et un filtre de couleur (21, 22, 23) sur un côté électroluminescent du dispositif électroluminescent (3) ; le filtre de couleur de la pluralité de sous-pixels (01, 02, 03) comprend un premier filtre de couleur (21) et un deuxième filtre de couleur (22) qui sont adjacents, une couleur de transmission de lumière du premier filtre de couleur (21) et une couleur de transmission de lumière du deuxième filtre de couleur (22) sont différentes l'une de l'autre, et une transmittance de lumière du deuxième filtre de couleur (22) est plus petite qu'une transmittance de lumière du premier filtre de couleur (21) ;
le premier filtre de couleur (21) comprend une première partie de transmission de lumière (210) et une première partie périphérique, la première partie de transmission de lumière (210) est configurée pour permettre à une lumière du sous-pixel où se trouve la première partie de transmission de lumière (210) de la traverser pour émettre à partir du panneau d'affichage (10) ; la première partie périphérique entoure au moins partiellement la première partie de transmission de lumière (210), et comprend une première partie (211) située sur un côté de la première partie de transmission de lumière (210) proche du deuxième filtre de couleur (22) ;
le deuxième filtre de couleur (22) comprend une deuxième partie de transmission de lumière (220) et une deuxième partie périphérique, la deuxième partie de transmission de lumière (220) est configurée pour permettre à une lumière du sous-pixel où se trouve la deuxième partie de transmission de lumière (220) de la traverser pour émettre à partir du panneau d'affichage (10) ; la deuxième partie périphérique entoure au moins partiellement la deuxième partie de transmission de lumière (220), et comprend une première partie (221) située sur un côté de la deuxième partie de transmission de lumière (220) proche du premier filtre de couleur (21) ;
la première partie (221) de la deuxième partie périphérique comprend une pluralité de sous-couches qui se chevauchent au moins partiellement et qui sont espacées les unes des autres dans une direction longitudinale perpendiculaire à la surface principale (1a) du substrat (1), la pluralité de sous-couches comprend une première sous-couche (221a) et une deuxième sous-couche (221b), et au moins une partie de la première partie (211) de la première partie périphérique est située entre la première sous-couche (221a) et la deuxième sous-couche (221b) dans la direction longitudinale ;
la première partie (211) de la première partie périphérique comprend une partie intérieure (211a),
la première sous-couche (221a) se trouve sur un côté de la deuxième sous-couche (221b) proche du substrat (1) ;
une direction dans laquelle le premier filtre de couleur (21) et le deuxième filtre de couleur (22) sont agencés est une direction latérale ; **caractérisé en ce que** :
la partie intérieure (211a) est intercalée entre la première sous-couche (221a) et la deuxième sous-couche (221b), dans lequel la partie intérieure (211a) est chevauchée à la fois par la première sous-couche (221a) et la deuxième sous-couche (221b) dans la direction longitudinale ; la première sous-couche (221a) recouvre et est en contact avec une surface de la partie intérieure (211a) faisant face au substrat (1), et la deuxième sous-couche (221b) recouvre et est en contact avec une surface de la partie intérieure (211a) éloignée du substrat (1) ;
une projection orthographique de la première sous-couche (221a) sur la surface principale (1a) du substrat (1) se trouve à l'intérieur d'une projection orthographique de la deuxième sous-couche (221b) sur la surface principale (1a) du substrat (1), et une aire de la projection orthographique de la première sous-couche (221a) sur la surface (1a) du substrat (1) est plus petite qu'une aire de la projection orthographique de la deuxième sous-couche (221b) sur la surface principale (1a) du substrat (1) ; et
une largeur de la première sous-couche (221a) dans la direction latérale est plus petite qu'une largeur de la deuxième sous-couche (221b) dans la direction latérale.

2. Panneau d'affichage (10) selon la revendication 1, dans lequel le deuxième filtre de couleur (22) est un filtre de couleur bleue qui permet à une lumière bleue de le traverser.

3. Panneau d'affichage (10) selon la revendication 1, dans lequel la première partie (211) de la première partie périphérique comprend en outre une partie extérieure (211b), la partie extérieure (211b) est d'un seul tenant avec la partie intérieure (211a) et sur un côté de la partie intérieure (211a) proche de la première partie de transmission de lumière (210) dans la direction latérale, dans lequel la partie extérieure (211b) n'est pas chevauchée par la première sous-couche (221a) et est chevauchée par la deuxième sous-couche (221b) dans la direction longitudinale.

4. Panneau d'affichage (10) selon la revendication 3, dans lequel la partie extérieure (211b) recouvre une surface latérale (221a-1) de la première sous-couche (221a) et est en contact avec la surface latérale (221a-1) de la première sous-couche (221a), et la surface latérale (221a-1) de la première sous-couche (221a) est croisée par la direction latérale.

5. Panneau d'affichage (10) selon l'une quelconque des revendications 1 à 4, dans lequel la première sous-couche (221a) se trouve sur un côté de la deuxième sous-couche (221b) proche du substrat (1) ; et
une épaisseur de la première sous-couche (221a) dans la direction longitudinale est plus grande qu'une épaisseur de la deuxième sous-couche (221b) dans la direction longitudinale.

6. Panneau d'affichage (10) selon l'une quelconque des revendications 1 à 5, dans lequel la première partie (211) de la première partie périphérique comprend une pluralité de sous-couches qui se chevauchent au moins partiellement dans la direction longitudinale et qui sont espacées les unes des autres dans la direction longitudinale ; et
la pluralité de sous-couches de la première partie (211) de la première partie périphérique et la pluralité de sous-couches de la première partie (221) de la deuxième partie périphérique sont empilées de manière alternée dans la direction longitudinale.

7. Panneau d'affichage (10) selon la revendication 6, dans lequel, parmi la pluralité de sous-couches de la première partie (211) de la première partie périphérique et la pluralité de sous-couches de la première partie (221) de la deuxième partie périphérique, la première sous-couche est la plus proche du substrat (1) ;
le panneau d'affichage (10) comprend en outre :
une couche plate (5), recouvrant la surface principale (1a) du substrat (1) et présentant une surface plate éloignée du substrat (1), dans lequel le premier filtre de couleur (21) et le deuxième filtre de couleur (22) sont situés sur la surface plate, et la première sous-couche (221a) est en contact avec la surface plate.

8. Panneau d'affichage (10) selon la revendication 6, dans lequel, parmi la pluralité de sous-couches de la première partie (211) de la première partie périphérique et la pluralité de sous-couches de la première partie (221) de la deuxième partie périphérique, la deuxième sous-couche (221b) est la plus éloignée du substrat (1).

9. Panneau d'affichage (10) selon l'une quelconque des revendications 6 à 8, dans lequel la pluralité de sous-couches de la première partie (221) de la deuxième partie périphérique sont agencées dans la direction longitudinale et, dans une direction de la proximité du substrat (1) à l'éloignement du substrat (1), des épaisseurs de la pluralité de sous-couches dans la direction longitudinale de la première partie (221) de la deuxième partie périphérique diminuent progressivement.

10. Panneau d'affichage (10) selon l'une quelconque des revendications 6 à 9, dans lequel une direction dans laquelle le premier filtre de couleur (21) et le deuxième filtre de couleur (22) sont agencés est une direction latérale ;
la pluralité de sous-couches de la première partie (221) de la deuxième partie périphérique sont agencées dans la direction longitudinale et, dans une direction de la proximité du substrat (1) à l'éloignement du substrat (1), des largeurs de la pluralité de sous-couches de la première partie (221) de la deuxième partie périphérique dans la direction latérale augmentent progressivement.

11. Panneau d'affichage (10) selon l'une quelconque des revendications 1 à 10, dans lequel le filtre de couleur de la pluralité de sous-pixels (01, 02, 03) comprend en outre un troisième filtre de couleur (23) adjacent au deuxième filtre de couleur (22) et sur un côté du deuxième filtre de couleur (22) éloigné du premier filtre de couleur (21), des couleurs de transmission de lumière du premier filtre de couleur (21), du deuxième filtre de couleur (22) et du troisième filtre de couleur (23) sont différentes les unes des autres, et la transmittance de lumière du deuxième filtre de couleur (22) est plus petite qu'une transmittance de lumière du troisième filtre de couleur (23) ;
le troisième filtre de couleur (23) comprend une troisième partie de transmission de lumière (230) et une troisième partie périphérique, la troisième partie de transmission de lumière (230) est configurée pour permettre à une lumière du sous-pixel où se trouve la troisième partie de transmission de lumière (230) de la traverser pour émettre à partir du panneau d'affichage (10) ; la troisième partie périphérique entoure au moins partiellement la troisième partie de transmission de lumière (230), et la troisième partie périphérique comprend une première partie (231) sur un côté de la troisième partie de transmission de lumière (230) proche du deuxième filtre de couleur (22) ;
la deuxième partie périphérique comprend en outre une deuxième partie (222) sur un côté de la deuxième partie de transmission de lumière (220) proche du troisième filtre de couleur (23) ;
la deuxième partie (222) de la deuxième partie périphérique comprend une pluralité de sous-couches qui se chevauchent au moins partiellement dans la direction longitudinale perpendiculaire à la surface principale (1a) du substrat (1) et qui sont espacées les unes des autres dans la direction longitudinale, la pluralité de sous-couches de la deuxième partie (222) de la deuxième partie périphérique comprend une troisième sous-couche (222a) et une quatrième sous-couche (222b), et au moins une partie de la première partie (231) de la troisième partie périphérique est située entre la troisième sous-couche (222a) et la quatrième sous-couche (222b) dans la direction longitudinale ;
le premier filtre de couleur (21) est un filtre de couleur verte qui permet à une lumière verte de le traverser, et le troisième filtre de couleur (23) est un filtre de couleur rouge qui permet à une lumière rouge de le traverser.

12. Panneau d'affichage (10) selon l'une quelconque des revendications 1 à 10, dans lequel le filtre de couleur de la pluralité de sous-pixels (01, 02, 03) comprend en outre un troisième filtre de couleur (23) adjacent au deuxième filtre de couleur (22) et sur un côté du deuxième filtre de couleur (22) éloigné du premier filtre de couleur (21), des couleurs de transmission de lumière du premier filtre de couleur (21), du deuxième filtre de couleur (22) et du troisième filtre de couleur (23) sont différentes les unes des autres, et la transmittance de lumière du deuxième filtre de couleur (22) est plus petite qu'une transmittance de lumière du troisième filtre de couleur (23) ;
le troisième filtre de couleur (23) comprend une troisième partie de transmission de lumière (230) et une troisième partie périphérique, la troisième partie de transmission de lumière (230) est configurée pour permettre à une lumière du sous-pixel où se trouve la troisième partie de transmission de lumière (230) de la traverser pour émettre à partir du panneau d'affichage (10) ; la troisième partie périphérique entoure au moins partiellement la troisième partie de transmission de lumière (230), et la troisième partie périphérique comprend une première partie (231) sur un côté de la troisième partie de transmission de lumière (230) proche du deuxième filtre de couleur (22) ;
la deuxième partie périphérique comprend en outre une deuxième partie (222) sur un côté de la deuxième partie de transmission de lumière (220) proche du troisième filtre de couleur (23) ;
la deuxième partie (222) de la deuxième partie périphérique comprend une pluralité de sous-couches qui se chevauchent au moins partiellement dans la direction longitudinale perpendiculaire à la surface principale (1a) du substrat (1) et qui sont espacées les unes des autres dans la direction longitudinale, la pluralité de sous-couches de la deuxième partie (222) de la deuxième partie périphérique comprend une troisième sous-couche (222a) et une quatrième sous-couche (222b), et au moins une partie de la première partie (231) de la troisième partie périphérique est située entre la troisième sous-couche (222a) et la quatrième sous-couche (222b) dans la direction longitudinale ;
le deuxième filtre de couleur (22) est sensiblement axisymétrique par rapport à un axe de symétrie le long de la direction longitudinale, et la première partie périphérique et la troisième partie périphérique sont sensiblement axisymétriques par rapport à l'axe de symétrie ; et
une section transversale du deuxième filtre de couleur (22) dans la direction longitudinale est sensiblement en forme de I.

13. Panneau d'affichage (10) selon l'une quelconque des revendications 11 et 12, dans lequel l'un du premier filtre de couleur (21), l'un du deuxième filtre de couleur (22), et l'un du troisième filtre de couleur (23) qui sont séquentiellement agencés dans l'ordre constituent une unité de répétition, et une pluralité des unités de répétition sont agencées de manière répétée pour fournir l'un du filtre de couleur pour chacun de la pluralité de sous-pixels (01, 02, 03) ;
dans l'une des unités de répétition, la première partie périphérique comprend en outre une deuxième partie (212) sur un côté de la première partie de transmission de lumière (210) éloigné du deuxième filtre de couleur (22), et la troisième partie périphérique comprend en outre une deuxième partie (212) sur un côté de la troisième partie de transmission de lumière (230) proche du premier filtre de couleur (21) d'une unité de répétition adjacente ; et
la deuxième partie (212) de la première partie périphérique comprend une pluralité de sous-couches qui se chevauchent au moins partiellement dans la direction longitudinale perpendiculaire à la surface principale (1a) du substrat (1) et qui sont espacées les unes des autres dans la direction longitudinale, la pluralité de sous-couches de la deuxième partie (212) de la première partie périphérique comprennent une cinquième sous-couche (212a) et une sixième sous-couche (212b), et au moins une partie d'une deuxième partie (232) de la troisième partie périphérique du troisième filtre de couleur (23) dans l'unité de répétition adjacente à l'une des unités de répétition est située entre la cinquième sous-couche (212a) et la sixième sous-couche (212b) dans la direction longitudinale ;
dans l'une des unités de répétition, une forme et une taille de la deuxième partie (212) de la première partie périphérique sont identiques respectivement à une forme et à une taille de la première partie (221) de la deuxième partie périphérique ;
une forme et une taille de la deuxième partie (232) de la troisième partie périphérique sont identiques respectivement à une forme et à une taille de la première partie (212) de la première partie périphérique ; et
une section transversale du troisième filtre de couleur (23) dans la direction longitudinale est en forme de T.

14. Appareil d'affichage (100), comprenant le panneau d'affichage (10) selon l'une quelconque des revendications 1 à 13.
